# EUROPEAN PATENT SPECIFICATION

(11) **EP 3 587 618 B1**
(45) Date of publication and mention of the grant of the patent: **01.03.2023**
(21) Application number: 19178468.5
(22) Date of filing: 05.06.2019
(51) Int. Cl.: C23C 14/04, C23C 14/22, C23C 14/24, C23C 14/32, B33Y 10/00

(54) **SELECTIVE VAPOR DEPOSITION PROCESS FOR ADDITIVE MANUFACTURING**
VERFAHREN ZUR SELEKTIVEN DAMPFABSCHEIDUNG ZUR GENERATIVEN FERTIGUNG
PROCÉDÉ DE DÉPÔT SÉLECTIF DE VAPEUR POUR FABRICATION ADDITIVE

(30) Priority: 05.06.2018 US 201816000560
(43) Date of publication of application: 01.01.2020
(73) Proprietor: Raytheon Technologies Corporation, Farmington, CT 06032 (US)
(72) Inventor: MARTIN, Thomas J., East Hampton, CT Connecticut 06424 (US); MIRONETS, Sergey, Charlotte, NC North Carolina 28202 (US); STAROSELSKY, Alexander, Avon, CT Connecticut 06001 (US); NARDI, Aaron T., East Granby, CT Connecticut 06026 (US)
(74) Representative: Dehns

(56) References cited:
- CN-U- 206 553 622
- DE-A1- 2 548 357
- KR-A- 20130 005 163
- KR-A- 20130 007 343
- US-A1- 2009 288 601

## Description

### BACKGROUND

Exemplary embodiments of the present disclosure relate generally to a selective vapor deposition process and, in one embodiment, to a selective vapor deposition process for additive manufacturing.

Discovery and development of vacuum technology, electricity, magnetism, gaseous chemistry, plasma technology, thermal evaporation, arcing and sputtering led to many advances in thin films and coatings technology. There are now many types of deposition processes, which can be qualified, based on the source material and method of deposition. For example, physical vapor deposition (PVD) begins with a condensed phase as a liquid or solid source is heated to a vapor phase and then cools to a condensed solid phase on a target build surface. Chemical vapor deposition (CVD) uses a chemical reaction to produce the vapor which decomposes onto the substrate. These processes are further characterized by the source of energy and method of deposition. For example, cathodic arc uses electric arc discharge to vaporize the source material to an ionic vapor, and electron beam physical vapor deposition (EB-PVD) uses an energetic electron beam to ablate the source material.

Each technology and its derivatives has distinct advantages and limitations based on criteria such as cost, film thickness, deposition rate, source material availability, porosity, and compositional control. There are some common constraints, however, that limit the implementation of these deposition technologies. Many depositions processes allow only line-of-sight transfer and others produce unavoidable deposition of source material on all surfaces interior to the vacuum chamber, including the holding fixtures.

KR 2013 0005163, KR 2013 0007343, DE 25 48 357 and US 2009/288601 disclose vapor deposition apparatus including a nozzle utilizing the venturi effect for accelerating precursor vapor towards a target substrate.

### BRIEF DESCRIPTION

According to an aspect of the disclosure, a selective vapor deposition method is provided as claimed in claim 1.

The evaporating of the precursor material may include cathodic arc evaporation.

The method may further include coupling the target build surface to a multi-axis robotic arm.

The precursor material may be evaporated, vaporized, sputtered or ablated in at least one of a crucible, a boat or an ingot inside the low vacuum evaporating chamber using at least one of an electrical resistance heater, an electron beam, a cathodic arc, an ion beam and a laser beam.

The evacuating of the precursor vapor into the nozzle may include flowing an inert gas through the nozzle to entrain the precursor vapor.

The method may further include capturing and recycling unused precursor vapor.

The accelerating of the precursor vapor through the diffuser may include electro-magnetically repelling the precursor vapor.

The electro-magnetically repelling the precursor vapor may include charging the precursor vapor with a predefined charge in at least one of the low vacuum evaporization chamber, the nozzle and the diffuser and charging an interior surface of at least a portion of the diffuser with the predefined charge.

The method may further include directing electro-magnetic attraction of the precursor vapor toward the target build surface.

The method may further include controlling electro-magnetic repulsion of the precursor vapor along at least the portion of the diffuser.

According to another aspect of the disclosure, a selective vapor deposition apparatus as claimed in claim 8

The target build surface support frame may include a multi-axis robotic arm.

The low vacuum evaporating chamber may include at least one of a crucible, a boat and an ingot, and the precursor material may be evaporated, vaporized, sputtered or ablated by at least one of an electrical resistance heater, an electron beam, a cathodic arc, an ion beam and a laser beam.

A capture and recycle system may capture and recycle unused precursor vapor. Wherein at least the diffuser electro-magnetically may repel the precursor vapor.

The precursor vapor and at least an interior surface of a portion of the diffuser may have a same charge.

Electro-magnetic attraction may be directed toward the target build surface.

The electro-magnetic repulsion is controllable along a portion of the diffuser.

These and other advantages and features will become more apparent from the following description taken in conjunction with the drawings.

### BRIEF DESCRIPTION OF THE DRAWINGS

The following descriptions should not be considered limiting and are provided by way of example only. With reference to the accompanying drawings, like elements are numbered alike:
FIG. 1 is a schematic diagram of a selective vapor deposition apparatus
FIG. 2 is a schematic diagram of a capture and recycle system of the selective vapor deposition apparatus of FIG. 1
FIG. 3 is a schematic side view of a segmented venturi element in accordance with the invention;
FIG. 4 is a schematic diagram illustrating components of a control element of the selective vapor deposition apparatus of FIGS. 1-3; and
FIG. 5 is a flow diagram illustrating a selective vapor deposition method

These and other advantages and features will become more apparent from the following description taken in conjunction with the drawings.

### DETAILED DESCRIPTION

A detailed description of one or more embodiments of the disclosed apparatus and method are presented herein by way of exemplification and not limitation with reference to the Figures.

As will be described below, a method is provided for executing targeted deposition of gaseous precursor materials on specific areas of a build surface. The proposed deposition process is a form of evaporation deposition, where the precursor material is evaporated by a heating element or vaporized by an energy source into a low vacuum evaporating chamber and is then evacuated out of the chamber into a venturi nozzle of a flowing inert gas, such as argon, drawn by venturi effect. The nozzle accelerates the precursor rich gas to selectively deposit the vapor material onto the target build surface. The entire system can be under protective atmosphere in a low pressure containment enclosure. The substrate is attached to a multi-axis robotic arm, within the enclosure, and can be controlled by a computer. Clogging of the nozzle by deposition of precursor material can be avoided by electro-magnetic repulsion. Deposition on the target build surface can be increased, enhanced and controlled by electro-magnetic attraction.

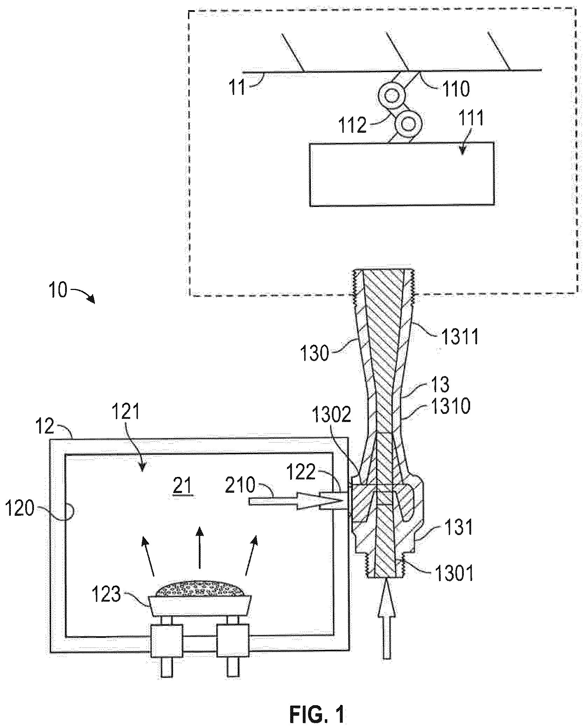

With reference to FIG. 1, a selective vapor deposition apparatus 10 is provided and includes a target build surface support frame 11, a low vacuum evaporization chamber 12 and a venturi element 13. The target build surface support frame 11 has a portion 110 thereof on which a target build surface 111 is disposable. The target build surface support frame 11 may also include a multi-axis robotic arm 112 that is controllable and allow the target build surface support frame 11 to maneuver the target build surface 111 in multiple axes and with multiple degrees of freedom. The heating chamber 12 is a body 120 that is formed to define an interior 121 and an outlet 122 through which the interior 121 is communicative with an exterior of the low vacuum evaporating chamber 12. The low vacuum evaporating chamber 12 may include at least one of a crucible, a boat and an ingot 123 in which a precursor material 20 may be provided and in which the precursor material 20 may be evaporated, vaporized, sputtered or ablated by at least one of electrical resistance heater, electron beam, cathodic arc, ion beam sputtering, and laser beam to produce a precursor vapor 21 (illustrated by the arrow 210 of FIG. 1 which is drawn to indicate that the precursor vapor 21 is exiting the heating chamber).

In accordance with embodiments, cathodic arc evaporation in particular involves striking a cathode substrate that includes source material with a high current, low voltage arc in order to produce the precursor vapor by sputtering. The cathodic spot can be controlled by the application of an electromagnetic field which moves the arc over the cathodic substrate. This cathodic process produces a precursor vapor of neutral, dissociated and ionized particles and allows for initially executing a sputtering process at the target build surface 111.

The precursor material 20 may be selected from various materials. The various materials include, but are not limited to, both metals, ceramics, intermetallics, and any of those which can be deposited as the precursor vapor 21 onto the target build surface 111.

The venturi element 13 includes a nozzle 130 and a diffuser 131. The nozzle 130 includes a first inlet 1301 and a second inlet 1302. The first inlet 1301 has a converging flow area and may be receptive of a flow of an inert gas, such as argon. The second inlet 1302 also has a converging flow area that intersects with a downstream portion of the first inlet 1301. Thus, the flow of the inert gas effectively entrains a flow of fluidic materials, such as the precursor vapor 21 into and through the second inlet 1302 so that it mixes with the flow of the inert gas leaving the first inlet 1301. The diffuser 131 includes a narrow section 1310, which is downstream from the first inlet 1301 and the second inlet 1302, and a diverging section 1311, which is downstream from the narrow section 1310. Where the precursor vapor 21 is entrained into the flow of an inert gas in the nozzle 130 (again with the flow of the precursor vapor 21 leaving the heating chamber 12 as illustrated by the arrow 210 in FIG. 1), the precursor vapor 21 and the inert gas flow through the narrow section 1310 and the diverging section 1311 of the diffuser 131.

As shown in FIG. 1, the venturi element 13 is disposable such that the second inlet 1302 fluidly communicates with the outlet 122 and such that the diverging section 1311 of the diffuser 131 is aimed toward the target build surface 111. Thus, the precursor vapor 21 is entrained into the flow of the inert gas within the nozzle 130 and then flows with the inert gas through the diffuser 131 toward the target build surface 111. That is, the venturi element 131 as a whole is configured to evacuate the precursor vapor 21 from the interior 121 of the low vacuum evaporating chamber 12. The precursor vapor 21 subsequently flows through the nozzle 130 from the heating chamber 12 and is then accelerated through the diffuser 131 toward the target build surface 111.

While the target build surface support frame 11 may include the multi-axis robotic arm 112 as described above, it is to be understood that the venturi element 13 may also be provided with a multi-axis robotic arm. Thus, one or both of the target build surface support frame 11 and the venturi element 13 can be maneuvered relative to the other in multiple axes and with multiple degrees of freedom. During a depositional process, such relative movement can allow for the deposition of the precursor vapor 21 in relatively complex patterns.

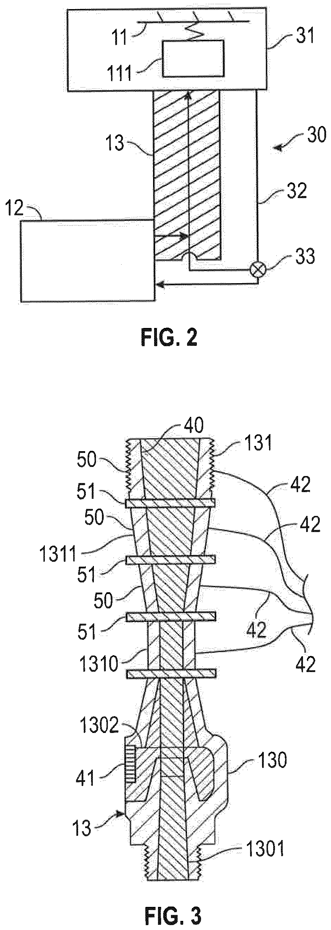

With reference to FIG. 2, the selective vapor deposition apparatus 10 may further include a capture and recycle system 30 for capturing and recycling unused precursor vapor 21 and inert gas. The capture and recycle system 30 may include a closed body 31, which surrounds the target build surface support frame 11 and the target build surface 111 and which can be purged of unused precursor vapor 21 and inert gas, and return piping 32 that returns the unused precursor vapor 21 and the inert gas to the heating chamber 12 and the first inlet 1301 (see FIG. 1), respectively. The return piping 32 may include a valve element 33 that is configured to separate the unused precursor vapor 21 from the inert gas.

With reference to FIGS. 1 and 3 at least a portion of an interior surface 40 of the diffuser 131 may be operable to electro-magnetically repel the precursor vapor 21. Such electro-magnetic repulsion may be executed to prevent the precursor vapor 21 from depositing, condensing onto or otherwise fouling the interior surface 40 and/or to accelerate the flows of the precursor vapor 21 through the diffuser 131 and toward the target build surface 111.

In accordance with the invention, the electro-magnetic repulsion may be executed by the provision of a first electrode 41 within the low vacuum evaporating chamber 12 or the nozzle 130 and a second electrode 42 in electrical communication with the diffuser 131. In such cases, energization of the first and second electrodes 41, 42 ionizes the precursor vapor 21 and applies a same charge to the interior surface 40 of the diffuser 131. Moreover, to an extent the entire interior surface 40 of the diffuser 131 can be charged, the electro-magnetic repulsion can prevent the deposting of the precursor vapor 21 on the interior surface 40 in the narrow section 1310 and can accelerate the precursor vapor 21 along the length of the diverging section 1311 toward the target build surface 111.

To an extent that the precursor vapor 21 is charged, the target build surface 111 can be oppositely charged. Such opposite charging will generate magnetic attraction between the precursor vapor 21 and the target build surface 111 and thus encourage deposition or, in some cases, increase a speed, power and/or efficiency of such deposition.

With reference to FIG. 3 and, in accordance with the invention, at least the diverging section 1311 of the diffuser 131 is formed of axial segments 50 that are electrically isolated from one another by dielectric material 51. These axial segments 50 are respectively coupled to corresponding second electrodes 42 that are sequentially energizable to generate an electro-magnetic repulsion pattern along the length of the diverging section 1311. This electro-magnetic repulsion pattern can be generated such that the acceleration of the precursor vapor 21 toward the target build surface 111 is controllable and timed.

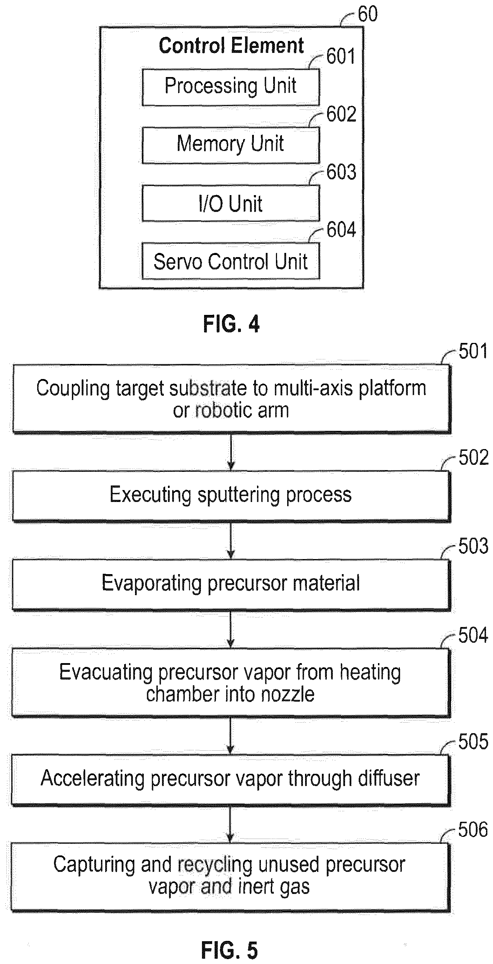

With reference to FIG. 4, the selective vapor deposition apparatus 10 may include a control element 60 that is operable to control the relative maneuvering of the venturi element 13 and the target build surface 111, operations of the low vacuum evaporating chamber 12 and the inert gas flow and the generation of the electro-magnetic repulsion. The control element 60 thus includes a processing unit 601, a memory unit 602 having executable instructions stored thereon which are readable and executable by the processing unit 601, input/output (I/O) unit 603 and a servo control unit 604. When the executable instructions are read and executed by the processing unit 601, the executable instructions cause the processing unit 601 to retrieve deposition instructions (i.e., in an additive manufacturing instance, the deposition instructions may include a part or component design as well as compositional instructions) as well as data and current condition information via the I/O unit 603, to calculate or otherwise generate operational commands for the various components of the target build surface support frame 11, the heating chamber 12, the venturi element 13, the capture and recycle system 30 and the first and second electrodes 41, 42 and to instruct the servo control unit 604 to execute the commands itself or to control the various components to execute.

With reference to FIG. 5, a selective vapor deposition method is provided for use with the selective vapor deposition apparatus 10 described above. As shown in FIG. 5, the method includes coupling the target build surface 111 to the multi-axis robotic arm 112 of the target build surface support frame 11 (501) and initially executing a sputtering process or another suitable process at the target build surface 111 to clean or prepare various surfaces thereof (502). The method further includes evaporating, vaporizing, sputtering or ablating the precursor material 20 in at least one of the crucible, a boat and ingot 123 inside the heating chamber 12 using at least one of electrical resistance heater, electron beam, cathodic arc, ion beam and laser beam to produce the precursor vapor 21 (503). At this point, the method includes evacuating the precursor vapor 21 into the nozzle 130 of the venturi element 13 by flowing the inert gas through the nozzle 130 to entrain the precursor vapor 21 (504). The precursor vapor 12 is then accelerated through the diffuser 131 of the venturi element 13 and toward the target build surface 111 (505). The accelerating of the precursor vapor 21 can be achieved by the entraining of the precursor vapor 21 into the flow of the inert gas and/or by the electro-magnetic repulsion. As an additional feature, the method may also include capturing and recycling unused precursor vapor 21 and inert gas for re-use (506).

Benefits of the features described herein are the provision of targeted deposition as opposed to existing vapor deposition methods, which cannot selectively control deposition. The selective vapor deposition apparatus 10 described above can be utilized for depositing thin and thick films on external surfaces of the target build surface 111 and most importantly on internal and out of sight surfaces of additively manufactured parts. The deposited layers will smooth such exterior and internal surfaces and will thus result in improved fatigue performance. The selective vapor deposition apparatus 10 and the method described above can be used in conjunction with cold spray deposition in which the precursor vapor 21 will be introduced to a cold spray carrier gas containing precursor powder. The precursor vapor 21 and cold spray powder can be selected to match a chemical composition of the target build surface 111, which can result in increased ductility and improved quality of the build. In addition, the selective vapor deposition apparatus 10 and the method described above can be controlled for in-situ micro-alloying of the target build surface 111 to selectively control and improve its mechanical properties.

Benefits of the features described herein are targeted delivery of a precursor material to specific areas at increased rate, controlled deposition and surface quality for additively manufactured parts, avoidance of deposition on internal and out of sight surfaces, elimination or minimization of a need for masking, modification and improvement to cold spray deposited layer, an allowance for in-situ micro alloying of powder particles and lower costs of deposition processes.

## Claims

1. A selective vapor deposition method, comprising:
evaporating a precursor material (20) in a low vacuum evaporating chamber (12) to produce a precursor vapor (21);
evacuating the precursor vapor into a nozzle (130) of a venturi element (13); and
accelerating the precursor vapor through a diffuser (131) of the venturi element and toward a target build surface (111), **characterized in that**
the diffuser comprises axial segments (50) respectively coupled to electrodes (42), and the accelerating comprises:
sequentially energizing the electrodes of each of the axial segments to generate an electro-magnetic repulsion pattern along a diverging section (1311) of the diffuser between the precursor vapor and an interior surface (40) of the diverging section; and
controlling and timing the electro-magnetic repulsion pattern of the precursor vapor along the diverging section of the diffuser.

2. The selective vapor deposition method according to claim 1, wherein the evaporating of the precursor material (20) comprises cathodic arc evaporation.

3. The selective vapor deposition method according to claim 1 or 2, further comprising coupling the target build surface (111) to a multi-axis robotic arm (112).

4. The selective vapor deposition method according to claim 1, 2 or 3, wherein the precursor material (20) is evaporated, vaporized, sputtered or ablated in at least one of a crucible, a boat or an ingot (123) inside the low vacuum evaporating chamber (12) using at least one of an electrical resistance heater, an electron beam, a cathodic arc, an ion beam and a laser beam.

5. The selective vapor deposition method according to any preceding claim, wherein the evacuating of the precursor vapor (21) into the nozzle (130) comprises flowing an inert gas through the nozzle to entrain the precursor vapor.

6. The selective vapor deposition method according to any preceding claim, further comprising capturing and recycling unused precursor vapor (21).

7. The selective vapor deposition method according to claim 1, further comprising:
charging the precursor vapor with a predefined charge in at least one of the low vacuum evaporization chamber (12), the nozzle (130) and the diffuser (131); and
charging an interior surface (40) of at least a portion of the diffuser with the predefined charge.

8. A selective vapor deposition apparatus, comprising:
a support frame (11) on a portion of which a target build surface (111) is disposable;
a low vacuum evaporating chamber (12) defining an outlet (122) in which a precursor material (20) is evaporated to produce a precursor vapor (21), which is depositable onto the target build surface; and
a venturi element (13) comprising a nozzle (130) and a diffuser (131) and disposable with an inlet (1302) of the nozzle adjacent to the outlet and the diffuser aimed toward the target build surface,
the venturi element being configured to evacuate the precursor vapor through the nozzle from the low vacuum evaporating chamber and to accelerate the precursor vapor through the diffuser toward the target build surface, **characterized in that**
the diffuser comprises axial segments (50) respectively coupled to electrodes (42),
the electrodes of each of the axial segments being sequentially energizable to generate an electro-magnetic repulsion pattern along a diverging section (1311) of the diffuser between the precursor vapor and an interior surface (40) of the diverging section, and
the electro-magnetic repulsion pattern of the precursor vapor along the diverging section of the diffuser is controllable and timable.

9. The selective vapor deposition apparatus according to claim 8, wherein the target build surface support frame (11) comprises at least one a multi-axis robotic arm (112).

10. The selective vapor deposition apparatus according to claim 8 or 9, wherein:
the low vacuum evaporating chamber (12) comprises at least one of a crucible, a boat and an ingot (123), and
the precursor material (20) is evaporated, vaporized, sputtered or ablated by at least one of an electrical resistance heater, an electron beam, a cathodic arc, an ion beam and a laser beam.

11. The selective vapor deposition apparatus according to claim 8, 9 or 10, further comprising a capture and recycle system (30) for capturing and recycling unused precursor vapor (21).

12. The selective vapor deposition apparatus according to any of claims 9 to 11,
wherein the apparatus is configured to provide the precursor vapor and at least an interior surface (40) of a portion of the diffuser with a same charge.

13. The selective vapor deposition apparatus according to claim 12, wherein the apparatus is arranged to direct electro-magnetic attraction toward the target build surface (111).

## Patentansprüche

1. Verfahren zur selektiven Dampfabscheidung, umfassend:
Verdampfen eines Vorläufermaterials (20) in einer Niedervakuum-Verdampfungskammer (12), um einen Vorläuferdampf (21) zu erzeugen;
Evakuieren des Vorläuferdampfes in eine Düse (130) eines Venturi-Elements (13); und
Beschleunigen des Vorläuferdampfes durch einen Diffusor (131) des Venturi-Elements und zu einer Zielaufbaufläche (111), **dadurch gekennzeichnet, dass**
der Diffusor axiale Segmente (50) umfasst, die jeweils mit Elektroden (42) gekoppelt sind, und das Beschleunigen umfasst:
sequentielles Erregen der Elektroden jedes der axialen Segmente, um ein elektromagnetisches Abstoßungsmuster entlang eines divergierenden Abschnitts (1311) des Diffusors zwischen dem Vorläuferdampf und einer Innenfläche (40) des divergierenden Abschnitts zu generieren; und
Steuern und zeitliches Steuern des elektromagnetischen Abstoßungsmusters des Vorläuferdampfes entlang des divergierenden Abschnitts des Diffusors.

2. Verfahren zur selektiven Dampfabscheidung nach Anspruch 1, wobei das Verdampfen des Vorläufermaterials (20) ein kathodisches Lichtbogenverdampfen umfasst.

3. Verfahren zur selektiven Dampfabscheidung nach Anspruch 1 oder 2, ferner umfassend das Koppeln der Zielaufbaufläche (111) mit einem mehrachsigen Roboterarm (112).

4. Verfahren zur selektiven Dampfabscheidung nach Anspruch 1, 2 oder 3, wobei das Vorläufermaterial (20) in mindestens einem von einem Tiegel, einem Schiff oder einem Barren (123) innerhalb der Niedervakuum-Verdampfungskammer (12) unter Verwendung mindestens eines von einem elektrischen Widerstandsheizer, einem Elektronenstrahl, einem kathodischen Lichtbogens, einem Ionenstrahl und einem Laserstrahl verdampft, verdunstet, zerstäubt oder abgetragen wird.

5. Verfahren zur selektiven Dampfabscheidung nach einem der vorhergehenden Ansprüche, wobei das Evakuieren des Vorläuferdampfes (21) in die Düse (130) das Strömen eines Inertgases durch die Düse umfasst, um den Vorläuferdampf mitzureißen.

6. Verfahren zur selektiven Dampfabscheidung nach einem der vorhergehenden Ansprüche, ferner umfassend das Auffangen und Recyceln von unverbrauchtem Vorläuferdampf (21).

7. Verfahren zur selektiven Dampfabscheidung nach Anspruch 1, ferner umfassend:
Laden des Vorläuferdampfes mit einer vordefinierten Ladung in mindestens einem von der Niedervakuum-Verdampfungskammer (12), der Düse (130) oder dem Diffusor (131); und
Laden einer Innenfläche (40) mindestens eines Teils des Diffusors mit der vordefinierten Ladung.

8. Gerät zur selektiven Dampfabscheidung, umfassend:
einen Stützrahmen (11), auf dessen einem Teil eine Zielaufbaufläche (111) angeordnet werden kann;
eine Niedervakuum-Verdampfungskammer (12), die einen Auslass (122) definiert, in dem ein Vorläufermaterial (20) verdampft wird, um einen Vorläuferdampf (21) zu erzeugen, der auf der Zielaufbaufläche abscheidbar ist; und
ein Venturi-Element (13), das eine Düse (130) und einen Diffusor (131) umfasst und so angeordnet werden kann, dass ein Einlass (1302) der Düse benachbart zu dem Auslass ist und der Diffusor auf die Zielaufbaufläche gerichtet ist,
wobei das Venturi-Element konfiguriert ist, um den Vorläuferdampf durch die Düse aus der Niedervakuum-Verdampfungskammer zu evakuieren und den Vorläuferdampf durch den Diffusor in Richtung der Zielaufbaufläche zu beschleunigen, **dadurch gekennzeichnet, dass**
der Diffusor axiale Segmente (50) umfasst, die jeweils mit Elektroden (42) gekoppelt sind,
die Elektroden jedes der axialen Segmente sequentiell erregbar sind, um ein elektromagnetisches Abstoßungsmuster entlang eines divergierenden Abschnitts (1311) des Diffusors zwischen dem Vorläuferdampf und einer Innenfläche (40) des divergierenden Abschnitts zu generieren; und
der elektromagnetischen Abstoßungsmusters des Vorläuferdampfes entlang des divergierenden Abschnitts des Diffusors steuerbar und zeitlich steuerbar ist.

9. Gerät zur selektiven Dampfabscheidung nach Anspruch 8, wobei der Stützrahmen (11) für die Zielaufbaufläche mindestens einen mehrachsigen Roboterarm (112) umfasst.

10. Gerät zur selektiven Dampfabscheidung nach Anspruch 8 oder 9, wobei:
die Niedervakuum-Verdampfungskammer (12) einen von einem Tiegel, einem Schiff und einem Barren (123) umfasst, und
das Vorläufermaterial (20) durch mindestens eines von einem elektrischen Widerstandsheizer, einem Elektronenstrahl, einem kathodischen Lichtbogens, einem Ionenstrahl und einem Laserstrahl verdampft, verdunstet, zerstäubt oder abgetragen wird.

11. Gerät zur selektiven Dampfabscheidung nach Anspruch 8, 9 oder 10, ferner umfassend ein Auffang- und Rückführungssystem (30) zum Auffangen und Rückführen von unverbrauchtem Vorläuferdampf (21).

12. Gerät zur selektiven Dampfabscheidung nach einem der Ansprüche 9 bis 11,
wobei das Gerät so konfiguriert ist, dass es den Vorläuferdampf und mindestens eine Innenfläche (40) eines Teils des Diffusors mit derselben Ladung bereitstellt.

13. Gerät zur selektiven Dampfabscheidung nach Anspruch 12, wobei das Gerät so angeordnet ist, dass es elektromagnetische Anziehung auf die Zielaufbaufläche (111) richtet.

## Revendications

1. Procédé de dépôt sélectif de vapeur, comprenant :
l'évaporation d'un matériau précurseur (20) dans une chambre d'évaporation à faible vide (12) pour produire une vapeur de précurseur (21) ;
l'évacuation de la vapeur de précurseur dans une buse (130) d'un élément venturi (13) ; et
l'accélération de la vapeur de précurseur à travers un diffuseur (131) de l'élément venturi et vers une surface de construction cible (111), **caractérisé en ce que**
le diffuseur comprend des segments axiaux (50) couplés respectivement à des électrodes (42), et l'accélération comprend :
l'excitation séquentielle des électrodes de chacun des segments axiaux pour générer un motif de répulsion électromagnétique le long d'une section divergente (1311) du diffuseur entre la vapeur de précurseur et une surface intérieure (40) de la section divergente ; et
la commande et la synchronisation du motif de répulsion électromagnétique de la vapeur de précurseur le long de la section divergente du diffuseur.

2. Procédé de dépôt sélectif de vapeur selon la revendication 1, dans lequel l'évaporation du matériau précurseur (20) comprend une évaporation à l'arc cathodique.

3. Procédé de dépôt sélectif de vapeur selon la revendication 1 ou 2, comprenant en outre le couplage de la surface de construction cible (111) à un bras robotique multiaxe (112).

4. Procédé de dépôt sélectif de vapeur selon la revendication 1, 2 ou 3, dans lequel le matériau précurseur (20) est évaporé, vaporisé, pulvérisé ou ablaté dans au moins l'un d'un creuset, d'une nacelle ou d'un lingot (123) à l'intérieur de la chambre d'évaporation à faible vide (12) à l'aide d'au moins l'un d'un élément chauffant à résistance électrique, d'un faisceau d'électrons, d'un arc cathodique, d'un faisceau d'ions et d'un faisceau laser.

5. Procédé de dépôt sélectif de vapeur selon une quelconque revendication précédente, dans lequel l'évacuation de la vapeur de précurseur (21) dans la buse (130) comprend l'écoulement d'un gaz inerte à travers la buse pour entraîner la vapeur de précurseur.

6. Procédé de dépôt sélectif de vapeur selon une quelconque revendication précédente, comprenant en outre la capture et le recyclage de la vapeur de précurseur inutilisée (21).

7. Procédé de dépôt sélectif de vapeur selon la revendication 1, comprenant en outre :
le chargement de la vapeur de précurseur avec une charge prédéfinie dans au moins l'un de la chambre d'évaporation à faible vide (12), de la buse (130) et du diffuseur (131) ; et
le chargement d'une surface intérieure (40) d'au moins une partie du diffuseur avec la charge prédéfinie.

8. Appareil de dépôt sélectif de vapeur, comprenant :
un cadre de support (11) sur une partie duquel une surface de construction cible (111) peut être déposée ;
une chambre d'évaporation à faible vide (12) définissant une sortie (122) dans laquelle un matériau précurseur (20) est évaporé pour produire une vapeur de précurseur (21), qui peut être déposée sur la surface de construction cible ; et
un élément venturi (13) comprenant une buse (130) et un diffuseur (131) et pouvant être déposé avec une entrée (1302) de la buse adjacente à la sortie et le diffuseur étant dirigé vers la surface de construction cible,
l'élément venturi étant configuré pour évacuer la vapeur de précurseur à travers la buse depuis la chambre d'évaporation à faible vide et pour accélérer la vapeur de précurseur à travers le diffuseur vers la surface de fabrication cible, **caractérisé en ce que**
le diffuseur comprend des segments axiaux (50) couplés respectivement à des électrodes (42),
les électrodes de chacun des segments axiaux étant excités séquentiellement pour générer un motif de répulsion électromagnétique le long d'une section divergente (1311) du diffuseur entre la vapeur de précurseur et une surface intérieure (40) de la section divergente, et
le motif de répulsion électromagnétique de la vapeur de précurseur le long de la section divergente du diffuseur peut être commandé et synchronisé.

9. Appareil de dépôt sélectif de vapeur selon la revendication 8, dans lequel le cadre de support de surface de construction cible (11) comprend au moins un bras robotique multiaxe (112).

10. Appareil de dépôt sélectif de vapeur selon la revendication 8 ou 9, dans lequel :
la chambre d'évaporation à faible vide (12) comprend au moins l'un d'un creuset, d'une nacelle et d'un lingot (123), et
le matériau précurseur (20) est évaporé, vaporisé, pulvérisé ou ablaté par au moins l'un d'un élément chauffant à résistance électrique, d'un faisceau d'électrons, d'un arc cathodique, d'un faisceau d'ions et d'un faisceau laser.

11. Appareil de dépôt sélectif de vapeur selon la revendication 8, 9 ou 10, comprenant en outre un système de capture et de recyclage (30) pour capturer et recycler la vapeur de précurseur inutilisée (21).

12. Appareil de dépôt sélectif de vapeur selon l'une quelconque des revendications 9 à 11,
dans lequel l'appareil est configuré pour fournir la vapeur de précurseur et au moins une surface intérieure (40) d'une partie du diffuseur avec une même charge.

13. Appareil de dépôt sélectif de vapeur selon la revendication 12, dans lequel l'appareil est agencé pour diriger l'attraction électromagnétique vers la surface de construction cible (111).
